# EUROPEAN PATENT APPLICATION

(11) **EP 4 851 254 A1**
(43) Date of publication of application: **09.12.2026**
(21) Application number: 25749216.5
(22) Date of filing: 21.01.2025
(51) Int. Cl.: C09D 1/00, C09D 7/63, C09D 7/61, C09D 5/32, C09D 7/20, C09K 11/02, C09K 11/66, C01G 21/00, H10K 30/10, H10K 30/30

(54) **COATING AGENT FOR FORMING LARGE-AREA PEROVSKITE THIN FILM AND METHOD FOR FORMING LARGE-AREA PEROVSKITE THIN FILM USING SAME**

(30) Priority: 02.02.2024 KR 20240016610
(71) Applicant: Hanwha Solutions Corporation, Jung-gu Seoul 04541 (KR)
(72) Inventor: CHOI, In Taek, Seoul 04541 (KR)
(74) Representative: Mooser, Sebastian Thomas
(86) International application number: PCT/KR2025/099096
(87) International publication number: WO 2025/165177

(57) **Abstract**

The present invention relates to: a method for forming a large-area perovskite thin film, enabling the manufacture of a high-quality large-area perovskite thin film; a coating agent used therefor; and a perovskite solar cell comprising same as a light-absorbing layer.

## Description

### TECHNICAL FIELD

The present invention relates to a method for forming a large-area perovskite thin film capable of manufacturing a high-quality large-area perovskite thin film, a coating agent used therefor, and a perovskite solar cell including the same as a light-absorbing layer.

### BACKGROUND ART

In order to solve the depletion of fossil energy and the global environmental problems caused by the usage thereof, research on renewable and clean alternative energy sources such as solar energy, wind power and hydropower is being actively conducted.

Among these, interest in solar cells, which directly convert electrical energy from sunlight, is greatly increasing. Here, a solar cell refers to a cell that generates current-voltage by utilizing the photovoltaic effect of absorbing light energy from sunlight to generate electrons and holes.

At present, it is possible to manufacture n-p diode-type silicon (Si) single-crystal-based solar cells having a light energy conversion efficiency exceeding 20%, which are actually used for photovoltaic power generation. There are also solar cells using compound semiconductors such as gallium arsenide (GaAs) having even higher conversion efficiency. However, since such inorganic semiconductor-based solar cells require materials refined to a very high purity for high efficiency, a large amount of energy is consumed in refining the raw materials. In addition, expensive process equipment is required in the process of single-crystallization or thin-film formation using the raw materials, and thus, there is a limit to lowering the manufacturing cost of solar cells, which has been an obstacle to large-scale utilization.

Accordingly, in order to manufacture solar cells at low cost, it is necessary to drastically reduce the cost of the materials or manufacturing processes used at the core of solar cells. As an alternative to inorganic semiconductor-based solar cells, research on perovskite solar cells that can be manufactured with low-cost materials and processes is being conducted.

A general structural formula of a perovskite structure is an AMX₃ structure, in which an anion is located at the X site, a large cation is located at the A site, and a small cation is located at the M site.

Such perovskite compounds have excellent electrical conductivity, charge mobility and optical properties, and thus have a wide range of applications. They have various characteristics including a long lifetime, a high absorption-wavelength spectrum due to a small energy band gap, and a wide charge-carrier diffusion length. At the same time, they have advantages in that the material cost is economical, they can be fabricated as a solution, the process cost is low, and they can be manufactured by a low-temperature process. Accordingly, they are attracting attention as promising materials for renewable energy applications, and in particular, research on using them as a light absorber for perovskite solar cells continues.

Among conventional solvents for dissolving perovskite precursors, dimethylformamide (DMF) and dimethyl sulfoxide (DMSO), which are representative polar aprotic solvents, were mixed and used. In particular, DMSO includes an (S=O) structure that can have a high dielectric constant value, and strongly binds to a cation (A⁺) such as CH₃NH₃⁺, which is a representative A-site material of perovskite. Through the formation of a base adduct in the form of AX·PbX₂·DMSO·Lewis (X = halogen ion), the perovskite nucleation/growth material of ABX₃ is suppressed, thereby forming a high-quality perovskite. However, because the solubility of materials such as caesium chloride compounds is low, when used as a solvent for a wide-band-gap perovskite precursor including triple-cation and triple-halide materials, the binding force is weak, and the Lewis base characteristic is reduced. Due to the low activation energy (Ea), the number of perovskite nucleation/growth materials increases such that a low-quality perovskite thin film having a small grain size is formed. As a result, conventional perovskite thin films formed by large-area coating have poor film uniformity and thermal stability, and because an anti-solvent treatment process is performed, waste is generated due to the use of the anti-solvent such that there is a limit in that the mass productivity of perovskite is poor.

### DISCLOSURE

### TECHNICAL PROBLEM

The present invention has been devised to overcome the above-described problems. The inventors of the present invention found that, in order to form a large-area perovskite thin film, when a Lewis base adduct former having a high dielectric constant value is introduced as a coating agent material for forming a perovskite thin film, the number of perovskite nucleation/growth materials is suppressed to maintain the intermediate phase for a long time such that a high-quality perovskite thin film having a large grain size can be formed, thereby completing the present invention. That is, the present invention is intended to provide a coating agent for forming a large-area perovskite thin film, a method for forming a large-area perovskite thin film using the same, and a solar cell including a perovskite thin film formed using the same as a light-absorbing layer.

### TECHNICAL SOLUTION

In order to solve the above-described problems, the present invention relates to a coating agent for forming a large-area perovskite thin film, including: a Lewis base adduct former including one or more selected from a compound represented by Chemical Formula 1 below, diphenyl carbonate, dialkyl dicarbonate and diaryl dicarbonate; and a perovskite precursor solution.

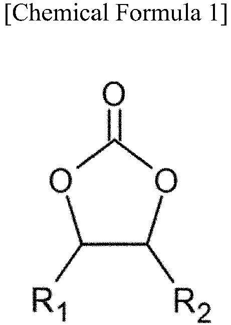

In Chemical Formula 1, R₁ and R₂ are each independently a hydrogen atom, a C₁-C₅ straight-chain alkyl group, a C₃-C₅ branched alkyl group or a phenyl group.

In a preferred embodiment of the present invention, the coating agent for forming a large-area perovskite thin film according to the present invention may include the Lewis base adduct former at a concentration of 5 mM to 100 mM.

In a preferred embodiment of the present invention, the perovskite precursor solution may include a perovskite precursor represented by Chemical Formula 2 below and a solvent.

[Chemical Formula 2] ABX₃

In Chemical Formula 2, A includes two or more selected from a monovalent organic ammonium ion and a monovalent inorganic cation, M is a divalent metal ion, and X includes two or more halogen ions selected from F⁻, Cl⁻, Br⁻ and I⁻.

In a preferred embodiment of the present invention, the perovskite precursor may be a perovskite precursor represented by Chemical Formula 3 below.

[Chemical Formula 3] AₘA'₁₋ₘB(XₙX'₁₋ₙ)₃

In Chemical Formula 3, A is methylammonium (MA), formamidinium (FA), ethylamine (EA), guanidinium (GA) or ethylenediamine (EDA), A' is Cs⁺, Na⁺, K⁺, NH₄⁺ or Rb⁺, B is Pb²⁺, Sn²⁺, Pd²⁺, Cu²⁺, Ge²⁺, Sr²⁺, Cd²⁺, Ca²⁺, Ni²⁺, Mn²⁺, Fe²⁺, Co²⁺, Sn²⁺, Yb²⁺ or Eu²⁺, X and X' are each independently Cl⁻, Br⁻, or I⁻, and m and n are rational numbers satisfying 0.6 ≤ m ≤ 0.9 and 0.5 ≤ n ≤ 0.9.

In a preferred embodiment of the present invention, the perovskite precursor solution may include the perovskite precursor at a concentration of 0.9 to 2.0 M.

In a preferred embodiment of the present invention, the solvent may include one or more selected from dimethyl sulfoxide (DMSO), N-methylpyrrolidone (NMP), thiourea, thioacetamide, pyridine, aniline, N,N'-dimethylpropyleneurea (DMPU), 1-cyclohexyl-2-pyrrolidone (CHP), acetonitrile (MeCN) and acetone.

Another object of the present invention relates to a method for forming a large-area perovskite thin film having an area of 200 cm² or more using the coating agent described above, the method including: step 1 of preparing the coating agent according to any one of claims 1 to 6; step 2 of forming a wet-thin film including perovskite that is crystallized as an intermediate phase by performing a coating process and drying of the coating agent on an upper portion of a substrate; and step 3 of forming a large-area perovskite thin film by performing an annealing process on the wet-thin film.

In a preferred embodiment of the present invention, the large-area perovskite thin film may have an average grain size of perovskite crystals on a surface of 300 nm or more.

In a preferred embodiment of the present invention, an upper portion of the substrate on which the coating agent is coated may be a Si thin-film layer, a hole transport layer, an electron transport layer or a passivation layer.

In a preferred embodiment of the present invention, the coating process may be performed by blade coating, slot-die coating, bar coating, inkjet coating or spray coating.

In a preferred embodiment of the present invention, the drying may be performed together with the coating process, or is performed after completion of the coating process.

In a preferred embodiment of the present invention, the drying may be performed by a N₂ or clean dry air (CDA) knife-blowing process to evaporate a solvent.

In a preferred embodiment of the present invention, the annealing may be performed by heat treatment at 95 to 150°C for 5 to 30 minutes.

Still another object of the present invention relates to a perovskite solar cell, including a large-area perovskite thin film formed by the above method using the coating agent as a light-absorbing layer (or a photoactive layer).

In a preferred embodiment of the present invention, the large-area perovskite thin film may have an average grain size of perovskite crystals on a surface of 300 nm or more.

In a preferred embodiment of the present invention, the perovskite solar cell may be a perovskite tandem solar cell.

In a preferred embodiment of the present invention, it may be a tandem solar cell, including: a top cell including a large-area perovskite thin film formed of the coating agent for forming a perovskite thin film described above as a light-absorbing layer; and a bottom cell including Si, Cu(In,Ga)Se₃, CdTe or a perovskite compound as a light-absorbing layer.

### ADVANTAGEOUS EFFECTS

In the coating agent for forming a perovskite thin film according to the present invention, a carbonate-based compound having a higher dielectric constant than a solvent such as dimethyl sulfoxide (DMSO) is introduced as a Lewis base adduct former. As a result, the binding force with the metal halide is strong such that the Lewis base characteristics of the adduct generated during the formation of the perovskite compound are not reduced. Due to the high activation energy (Ea), the number of perovskite nucleation/growth materials is suppressed such that the intermediate phase can be maintained for a long time. Consequently, a high-quality perovskite thin film having a large grain size can be formed. In addition, since a large-area perovskite thin film of 200 cm² or more can be manufactured, the efficiency of a large-area solar cell can be maximized.

### DESCRIPTION OF DRAWINGS

FIG. 1 is a set of SEM measurement images of the surfaces of perovskite thin films manufactured in Example 1 and Comparative Example 1.
FIG. 2 is a set of SEM measurement images of the cross-sections of perovskite thin films manufactured in Example 1 and Comparative Example 1.

### MODES OF THE INVENTION

Hereinafter, the present invention will be described in more detail through a method for forming a large-area perovskite thin film. Here, the large area means an area of 200 cm² or more, preferably 250 cm² or more.

The present invention may form and obtain a large-area perovskite thin film by performing a process including: step 1 of preparing a coating agent for forming a large-area perovskite thin film; step 2 of forming a wet-thin film including perovskite that is crystallized as an intermediate phase by performing a coating process and drying of the coating agent on an upper portion of a substrate; and step 3 of forming the following large-area perovskite thin film by performing an annealing process on the wet-thin film.

The coating agent for forming a large-area perovskite thin film of step 1 (hereinafter, referred to as the "coating agent") includes: a Lewis base adduct former including one or more selected from a compound represented by Chemical Formula 1 below, diphenyl carbonate, dialkyl dicarbonate and diaryl dicarbonate; and a perovskite precursor solution.

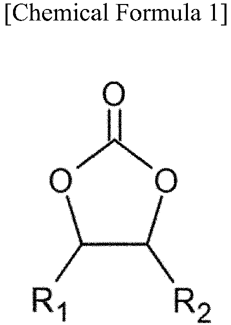

In Chemical Formula 1, R₁ and R₂ are each independently a hydrogen atom, a C₁-C₅ straight-chain alkyl group, a C₃-C₅ branched alkyl group or a phenyl group, preferably a hydrogen atom or a C₁-C₅ straight-chain alkyl group, and more preferably a hydrogen atom or a C₁-C₂ straight-chain alkyl group.

The coating agent may include the Lewis base adduct former at a concentration of 5 mM to 100 mM, preferably at a concentration of 5 mM to 50 mM, and more preferably at a concentration of 6 mM to 30 mM. In this case, if the concentration of the Lewis base adduct former in the coating agent is less than 5 mM, the amount used is too small such that there may be a problem that the grain size of the formed perovskite thin film is formed too small. Using more than 100 mM is an excessive amount, and on the contrary, a problem may occur in which the perovskite crystals are suppressed, or the perovskite grains are separated by grain boundaries due to an excessive grain size. Therefore, it is preferable to use it within the above range.

Among the components of the coating agent of step 1, the perovskite precursor solution may include a perovskite precursor represented by Chemical Formula 2 below and a solvent.

[Chemical Formula 2] ABX₃

In Chemical Formula 2, A includes two or more selected from a monovalent organic ammonium ion and a monovalent inorganic cation, M is a divalent metal ion, and X includes two or more halogen ions selected from F⁻, Cl⁻, Br⁻ and I⁻.

The perovskite precursor may preferably be a compound represented by Chemical Formula 3 below.

[Chemical Formula 3] AₘA'₁₋ₘB(XₙX'₁₋ₙ)₃

In Chemical Formula 3, A is methylammonium (MA), formamidinium (FA), ethylamine (EA), guanidinium (GA) or ethylenediamine (EDA), and A is preferably MA or FA.

Further, A' in Chemical Formula 3 is Cs⁺, Na⁺, K⁺, NH₄⁺ or Rb⁺, and is preferably Cs⁺ or Rb⁺.

In addition, B in Chemical Formula 3 is Pb²⁺, Sn²⁺, Pd²⁺, Cu²⁺, Ge²⁺, Sr²⁺, Cd²⁺, Ca²⁺, Ni²⁺, Mn²⁺, Fe²⁺, Co²⁺, Yb²⁺ or Eu²⁺, preferably Pb²⁺, Sn²⁺, Pd²⁺,or Cu²⁺, and more preferably Pb²⁺ or Sn²⁺.

Further, X and X' in Chemical Formula 3 are each independently Cl⁻, Br⁻ or I⁻.

Further, m and n in Chemical Formula 3 are rational numbers satisfying 0.6 ≤ m ≤ 0.9 and 0.5 ≤ n ≤ 0.9, preferably rational numbers satisfying 0.65 ≤ m ≤ 0.85 and 0.55 ≤ n ≤ 0.85, and more preferably rational numbers satisfying 0.70 ≤ m ≤ 0.85 and 0.60 ≤ n ≤ 0.85.

Further, the perovskite precursor solution may include the perovskite precursor at a concentration of 0.9 to 2.0 M, preferably at a concentration of 1.0 to 1.6 M, and more preferably at a concentration of 1.10 to 1.50 M. In this case, if the concentration of the perovskite precursor in the precursor solution is less than 0.9 M, the perovskite thickness is not sufficiently formed and the density is low such that there may be a problem in which the current converted by receiving light is reduced. If it is more than 2.0 M, there may be a problem in forming the wet-thin film, or a problem in that the margin time range until the post-treatment thermal process is insufficient due to a rapid shortage of solvent after formation.

Further, among the components of the perovskite precursor solution, the solvent may include one or more selected from dimethyl sulfoxide (DMSO), N-methylpyrrolidone (NMP), thiourea, thioacetamide, pyridine, aniline, N,N'-dimethylpropyleneurea (DMPU), 1-cyclohexyl-2-pyrrolidone (CHP), acetonitrile (MeCN) and acetone, and may preferably include one or more selected from DMSO, DMF, NMP, DMPU and CHP.

Next, the substrate of step 2 of the method for forming a large-area perovskite thin film according to the present invention means an object on which the coating liquid of step 1 is coated, and the coating liquid may be coated on an upper portion of a Si thin film, an upper portion of a hole transport layer, an upper portion of an electron transport layer, or an upper portion of a passivation layer.

Further, the coating process of step 2 may be performed by blade coating, slot-die coating, bar coating, inkjet coating or spray coating, and may preferably be performed by blade coating, slot-die coating or bar coating.

Further, the drying of step 2 may be performed together with the coating process, or the drying may be performed as a separate process after completion of the coating process. As a preferred example of the drying method, N₂ blowing through an air knife may be performed, and the solvent in the coating agent may be evaporated through drying, but the present invention is not limited thereto.

Further, when the drying is performed, a wet-thin film including perovskite crystallized as an intermediate phase is formed.

Next, the annealing of step 3 of the method for forming a large-area perovskite thin film according to the present invention may be performed by heat treatment at 95 to 150°C for 5 to 30 minutes, and may preferably be performed by heat treatment at 98 to 140°C for 5 to 30 minutes.

The large-area perovskite thin film formed by performing step 1 to step 3 described above has an average grain size of perovskite crystals present on a surface of 300 nm or more, preferably 350 nm to 800 nm, and more preferably 400 to 750 nm. Such a large-area perovskite thin film has excellent uniformity and thermal stability, and may be formed and manufactured with high mass productivity.

The present invention may provide a perovskite solar cell having excellent photoelectric conversion efficiency (PCE) by forming a light-absorbing layer of a solar cell using the coating agent and method for forming a perovskite thin film described above. The solar cell of the present invention may be a p-i-n structure perovskite solar cell, an inverted-structure perovskite solar cell, a tandem perovskite solar cell, a tandem silicon/perovskite heterojunction solar cell, or a tandem perovskite/perovskite heterojunction solar cell.

For example, in a tandem solar cell composed of a silicon bottom cell and a perovskite top cell, the light-absorbing layer of the top cell may be formed as a large-area perovskite light-absorbing layer by the coating agent and method of the present invention.

Further, in a tandem solar cell composed of a bottom cell including Cu(In,Ga)Se₃, CdTe or a perovskite compound as a light-absorbing layer, and a perovskite top cell, the light-absorbing layer of the top cell may be formed as a perovskite light-absorbing layer by the coating agent and method of the present invention.

Further, as a preferred embodiment of the perovskite solar cell, the solar cell includes a laminate having a structure in which a hole transport layer (HTL), a perovskite light-absorbing layer, an electron transport layer (ETL), a conductive barrier layer (passivation layer) and a source electrode are sequentially stacked.

Further, when the solar cell is an inverted-structure perovskite solar cell, the laminate may be stacked on an upper portion of a drain electrode.

Further, in the inverted-structure perovskite solar cell, a form in which a conductive substrate, a drain electrode, a hole transport layer, a light-absorbing layer, an electron transport layer and a source electrode are sequentially stacked may constitute one set, and the set may be formed by being stacked as a single layer or multiple layers.

Describing in detail through a method for manufacturing the laminate constituting the perovskite solar cell, the laminate may be manufactured by performing a process including: step 1 of forming an electron transport layer by coating a coating agent for forming an electron transport layer on an upper portion of the perovskite light-absorbing layer of a laminate including a hole transport layer and a perovskite light-absorbing layer; step 2 of forming a passivation layer through a deposition process on an upper portion of the electron transport layer; and step 3 of forming a source electrode on an upper portion of the passivation layer.

The hole transport layer (HTL) may include an inorganic and/or organic hole transport material. The inorganic hole transport material may include one or more selected from nickel oxide (NiOₓ), CuSCN, CuCrO₂ and CuI.

The organic hole transport material may include a carbazole derivative, a polyarylalkane derivative, a phenylenediamine derivative, an arylamine derivative, an amino-substituted chalcone derivative, a styrylanthracene derivative, a fluorene derivative, a hydrazone derivative, a stilbene derivative, a silazane derivative, an aromatic tertiary amine compound, a styrylamine compound, an aromatic dimethylidene-based compound, a porphyrin-based compound, a phthalocyanine-based compound, a polythiophene derivative, a polypyrrole derivative, a poly(para-phenylene vinylene) derivative, pentacene, coumarin 6 (coumarin 6, 3-(2-benzothiazolyl)-7-(diethylamino)coumarin), ZnPC (zinc phthalocyanine), CuPC(copper phthalocyanine), TiOPC (titanium oxide phthalocyanine), Spiro-MeOTAD (2,2',7,7'-tetrakis(N,N-p-dimethoxyphenylamino)-9,9'-spirobifluorene), F16CuPC (copper(II) 1,2,3,4,8,9,10,11,15,16,17,18,22,23,24,25-hexadecafluoro-29H,31H-phthalocyanine), SubPc (boron subphthalocyanine chloride) and N3 (cis-di(thiocyanato)-bis(2,2'-bipyridyl-4,4'-dicarboxylic acid)-ruthenium(II), P3HT(poly[3-hexylthiophene]), MDMO-PPV (poly[2-methoxy-5-(3',7'-dimethyloctyloxyl)]-1,4-phenylene vinylene), MEH-PPV (poly[2-methoxy-5-(2"-ethylhexyloxy)-p-phenylene vinylene]), P3OT (poly(3-octyl thiophene)), POT(poly(octyl thiophene)), P3DT (poly(3-decyl thiophene)), P3DDT (poly(3-dodecyl thiophene), PPV (poly(p-phenylene vinylene)), TFB (poly(9,9'-dioctylfluorene-co-N-(4-butylphenyl)diphenyl amine), polyaniline, Spiro-MeOTAD ([2,22',7,77'-tetrakis(N,N-di-pmethoxyphenyl amine)-9,9,9'-spirobi fluorine]), CuSCN, CuI, PCPDTBT (Poly[2,1,3-benzothiadiazole-4,7-diyl[4,4-bis(2-ethylhexyl-4H-cyclopenta [2,1-b:3,4-b']dithiophene-2,6-diyl]], Si-PCPDTBT (poly[(4,4'-bis(2-ethylhexyl)dithieno[3,2-b:2',3'-d]silole)-2,6-diyl-alt-(2,1,3-benzothiadiazole)-4,7-diyl]), PBDTTPD (poly((4,8-diethylhexyloxyl), PFDTBT (poly[2,7-(9-(2-ethylhexyl)-9-hexyl-fluorene)-alt-5,5-(4',7,-di-2-thienyl-2',1', 3'-benzothiadiazole)]), PFO-DBT (poly[2,7-.9,9-(dioctyl-fluorene)-alt-5,5-(4',7'-di-2-.thienyl-2', 1', 3'-benzothiadiazole)]), PSiFDTBT (poly[(2,7-dioctylsilafluorene)-2,7-diyl-alt-(4,7-bis(2-thienyl)-2,1,3-benzothiadiazole)-5,5'-diyl]), PCDTBT (Poly[[9-(1-octylnonyl)-9H-carbazole-2,7-diyl]-2,5-thiophenediyl-2,1,3-benzothiadiazole-4,7-diyl-2,5-thiophenediyl]), PFB (poly(9,9'-dioctylfluorene-co-bis(N,N'-(4,butylphenyl))bis(N,N'-phenyl-1,4-phenylene)diamine), F8BT (poly(9,9'-dioctylfluorene-cobenzothiadiazole), PEDOT (poly(3,4-ethylenedioxythiophene)), PEDOT:PSS poly(3,4-ethylenedioxythiophene) poly(styrenesulfonate), PTAA (poly(triarylamine)), 2-PACz, and/or MeO-2PACz.

Further, examples of the method for forming the hole transport layer include a coating method and a vacuum deposition method, and examples of the coating method include gravure coating, bar coating, printing, spraying, spin coating, dipping and die coating.

Next, the light-absorbing layer is a large-area thin-film layer formed by the coating agent and method of the present invention described above.

Next, the electron transport layer may include an inorganic material (e.g., a metal oxide) and/or an organic material. The electron transport layer may be a flat metal oxide layer, a metal oxide layer having surface irregularities, a metal oxide layer of a composite structure in which nanostructures (including metal oxide particles, nanowires and/or nanotubes) of the same or different metal oxide are formed on the surface of a thin-film metal oxide, or a porous metal oxide layer. It may preferably include a compact metal oxide layer and a meso-porous metal oxide layer, and preferred examples thereof may include TiO₂, SnO₂ and ZnO. In addition, the organic material may include PCBM.

Further, among the components of the solar cell, the upper electrode (or source electrode) may be formed by coating or depositing one or more materials selected from Pt, Au, Ni, Cu, Ag, In, Ru, Pd, Rh, Ir, Os, C and a conductive polymer.

Further, the solar cell may further include a passivation layer between the light-absorbing layer and the electron transport layer.

As still another preferred embodiment, when the solar cell of the present invention is a tandem silicon/perovskite heterojunction solar cell, it may be in a form in which a drain electrode, a silicon solar cell, a recombination layer and the laminate are sequentially stacked. In addition, as a preferred embodiment, it may be a tandem silicon/perovskite heterojunction solar cell in which a silicon solar cell substrate (first electrode)-ITO conductive transparent thin-film layer-hole transport layer-organic interfacial layer-large-area perovskite thin-film layer (light-absorbing layer)-electron transport layer-passivation layer (or buffer layer)-TCO layer-source electrode (second electrode) are sequentially stacked. In this case, the hole transport layer, the electron transport layer and the source electrode are the same as described above.

Hereinafter, the present invention will be described in more detail through examples, but the following examples do not limit the scope of the present invention, and should be construed as being provided to aid understanding of the present invention.

### [Example]

### Example 1: Preparations of perovskite coating agent and perovskite thin film

### (1) Preparation of perovskite precursor solution

CsBr, FAI and PbI₂ precursors were mixed to prepare a perovskite precursor solution including a perovskite compound represented by Chemical Formula 3-1 below at 1.3 M.

[Chemical Formula 3-1] AₘA'₁₋ₘB(XₙX'₁₋ₙ)₃

In Chemical Formula 3-1, A is formamidinium (FA), A' is Cs⁺, B is Pb²⁺, X is I⁻, X' is Br⁻, m is 0.8, and n is 0.8.

### (2) Preparation of coating agent for forming large-area perovskite thin film

The Lewis base adduct former represented by Chemical Formula 1-1 below was introduced into the perovskite precursor solution, and then stirred at about 25°C for 1 hour to prepare a coating agent for forming a large-area perovskite thin film. In this case, the concentration of the Lewis base adduct former in the coating agent was 10 mM.

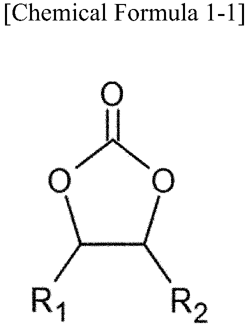

In Chemical Formula 1-1, R₁ and R₂ are hydrogen atoms.

### Comparative Example 1

The perovskite precursor solution prepared in Example 1 was prepared as a coating agent for forming a large-area perovskite thin film.

### Examples 2 to 4 and Comparative Example 2

Coating agents for forming a large-area perovskite thin film were prepared in the same manner as in Example 1, except that the concentration and type of the Lewis base adduct former were varied as shown in Table 1 below, to respectively carry out Examples 2 to 4 and Comparative Example 2.

### Examples 5 to 6 and Comparative Examples 3 to 4

Coating agents for forming a large-area perovskite thin film were prepared in the same manner as in Example 1, except that perovskite precursor solutions having different perovskite precursor concentrations were used as shown in Table 1 below, to respectively carry out Examples 5 to 6 and Comparative Examples 3 to 4.

### Example 7

A coating agent for forming a large-area perovskite thin film was prepared in the same manner as in Example 1, except that as the Lewis base adduct former, the Lewis base adduct former represented by Chemical Formula 1-2 below was used instead of Chemical Formula 1-1.

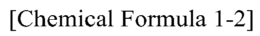

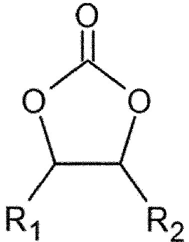

In Chemical Formula 1-1, R₁ and R₂ are methyl groups.

### Example 8

A coating agent for forming a large-area perovskite thin film was prepared in the same manner as in Example 1, except that as the Lewis base adduct former, the Lewis base adduct former represented by Chemical Formula 1-1 and diethyl carbonate were mixed and used at a weight ratio of 1 : 0.23.

### Example 9

A coating agent for forming a large-area perovskite thin film was prepared in the same manner as in Example 1, except that in the preparation of the perovskite precursor, a perovskite compound represented by Chemical Formula 3-2 below was used instead of the perovskite compound represented by Chemical Formula 3-1.

[Chemical Formula 3-2] AₘA'₁₋ₘB(XₙX'₁₋ₙ)₃

In Chemical Formula 3-2, A is methylammonium (MA), A' is Cs⁺, B is Pb²⁺, X is I⁻, X' is Br⁻, m is 0.72, and n is 0.64.

### Comparative Example 5

A coating agent for forming a large-area perovskite thin film was prepared in the same manner as in Example 1, except that in the preparation of the perovskite precursor, a perovskite compound represented by Chemical Formula 3-3 below was used instead of the perovskite compound represented by Chemical Formula 3-1.

[Chemical Formula 3-3] AₘA'₁₋ₘB(XₙX'₁₋ₙ)₃

In Chemical Formula 3-3, A is formamidinium (FA), A' is methylammonium (MA), B is Pb²⁺, X is I⁻, X' is Br⁻, m is 0.78, and n is 0.67.

**[Table 1]**

| Classification | Concentration of perovskite precursor in precursor solution | Concentration of Lewis base adduct former in coating agent | Type of Lewis base adduct former | Perovskite compound |
|---|---|---|---|---|
| Example 1 | 1.30 M | 10 mM | Chemical Formula 1-1 | Chemical Formula 3-1 |
| Example 2 | 1.30 M | 30 mM | Chemical Formula 1-1 | Chemical Formula 3-1 |
| Example 3 | 1.30 M | 50 mM | Chemical Formula 1-1 | Chemical Formula 3-1 |
| Example 4 | 1.30 M | 100 mM | Chemical Formula 1-1 | Chemical Formula 3-1 |
| Example 5 | 1.00 M | 30 mM | Chemical Formula 1-1 | Chemical Formula 3-1 |
| Example 6 | 1.80 M | 30 mM | Chemical Formula 1-1 | Chemical Formula 3-1 |
| Example 7 | 1.30 M | 30 mM | Chemical Formula 1-2 | Chemical Formula 3-1 |
| Example 8 | 1.30 M | 30 mM | Chemical Formula 1-1 and diethylcarbonate | Chemical Formula 3-1 |
| Example 9 | 1.30 M | 30 mM | Chemical Formula 1-1 | Chemical Formula 3-2 |
| Comparative Example 1 | 1.30 M | × | × | Chemical Formula 3-1 |
| Comparative Example 2 | 1.30 M | 115 mM | Chemical Formula 1-1 | Chemical Formula 3-1 |
| Comparative Example 3 | 0.80M | 30 mM | Chemical Formula 1-1 | Chemical Formula 3-1 |
| Comparative Example 4 | 2.10M | 30 mM | Chemical Formula 1-1 | Chemical Formula 3-1 |
| Comparative Example 5 | 1.50 M | 40 mM | Chemical Formula 1-1 | Chemical Formula 3-3 |

### Preparation Example 1: Manufacture of tandem silicon/perovskite heterojunction solar cell

As a first electrode, an ITO conductive thin film was deposited to 20 nm by physical vapor deposition on a silicon solar cell substrate of 6 inches in width and length. Then, NiOₓ was formed to 20 nm as a hole transport layer on the ITO conductive transparent substrate using a physical vapor deposition process.

Next, 200 µL of an organic interfacial layer solution was dropped onto the hole transport layer (NiOₓ), spin-coated at 3,000 rpm for 30 seconds, and then heat-treated at 100°C.

In this case, the organic interfacial layer solution was prepared by dissolving 2PACz ([2-(9H-carbazol-9-yl)ethyl]phosphonic acid) in an ethanol solvent at a concentration of 2 mM.

Next, the coating agent for forming a large-area perovskite thin film prepared in Example 1 was coated using blade equipment, the coated surface was blown with 99% nitrogen, and then heat-treated at 100°C for 20 minutes to form a light-absorbing layer having a thickness of about 550 to 560 nm and an area of about 233 cm².

Next, after forming a fullerene (C₆₀) layer having a thickness of 13 nm as an electron transport layer on an upper portion of the light-absorbing layer, 10 nm of SnO₂ was deposited on the electron transport layer by an ALD process. The SnO₂ serves two roles as an electron transport layer and a buffer layer.

Thereafter, a top TCO layer was formed to a thickness of 70 nm by physical vapor deposition, and finally, a second electrode of Ag was formed using thermal evaporation equipment to fabricate a large-area perovskite/silicon tandem photoelectric conversion device.

### Preparation Examples 2 to 9 and Comparative Preparation Examples 1 to 5

Large-area perovskite/silicon tandem photoelectric conversion devices were fabricated in the same manner as in Preparation Example 1, except that the coating agent for forming a large-area perovskite thin film was varied as shown in Table 2 below when preparing the light-absorbing layer, to respectively carry out Preparation Examples 2 to 9 and Comparative Preparation Examples 1 to 5.

### Experimental Example 1: Measurements of scanning electron microscope (SEM) and average grain size of light-absorbing layer

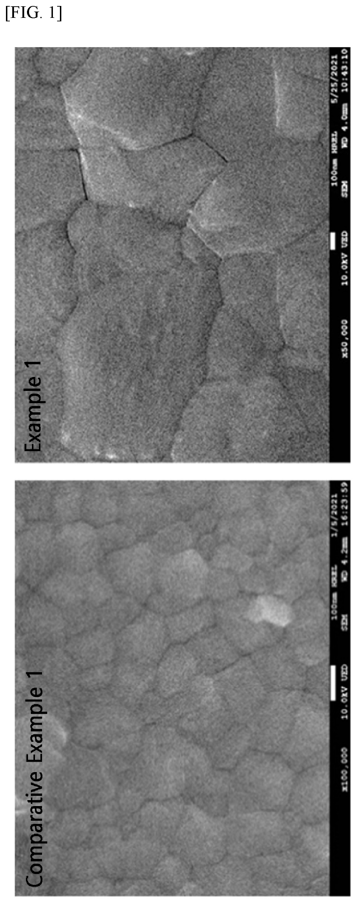

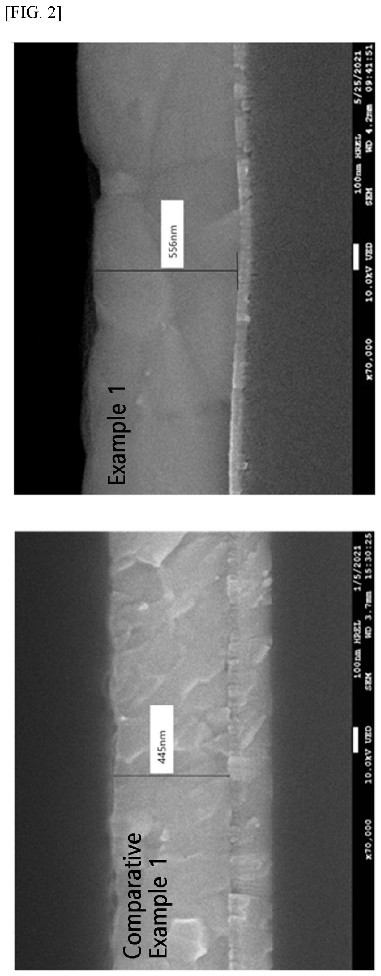

SEM images of the surface of the light-absorbing layers of the tandem photoelectric conversion devices of Preparation Example 1 (Example 1) and Comparative Preparation Example 1 (Comparative Example 1) are shown in FIG. 1, and SEM measurement images of the cross-section are shown in FIG. 2. The perovskite crystal form constituting the light-absorbing layer is a plate-like form.

In addition, the average grain size of the perovskite crystals that were present on the surface of the perovskite thin film constituting the light-absorbing layers of the Preparation Examples and Comparative Preparation Examples was measured, and the results are shown in Table 2 below.

**[Table 2]**

| Classification | Type of coating agent for forming large-area perovskite thin film | Thickness of light-absorbing layer (nm) | Average grain size of surface (nm) | PbI₂ detection (not reacted) |
|---|---|---|---|---|
| Preparation Example 1 | Example 1 | 550 ~ 560 | 500 ~ 550 | Not detected |
| Preparation Example 2 | Example 2 | 570 ~ 620 | 550 ~ 600 | Not detected |
| Preparation Example 3 | Example 3 | 600 ~ 700 | 700 ~ 710 | Not detected |
| Preparation Example 4 | Example 4 | 700 ~ 800 | 740 ~ 750 | Not detected |
| Preparation Example 5 | Example 5 | 400 ~ 450 | 380 ~ 440 | Not detected |
| Preparation Example 6 | Example 6 | 760 ~ 800 | 750 ~ 790 | Not detected |
| Preparation Example 7 | Example 7 | 560 ~ 610 | 540 ~ 590 | Not detected |
| Preparation Example 8 | Example 8 | 570 ~ 625 | 560 ~ 610 | Not detected |
| Preparation Example 9 | Example 9 | 565 ~ 615 | 550 ~ 600 | Not detected |
| Comparative Preparation Example 1 | Comparative Example 1 | 440 ~ 450 | 74 ~ 150 | Not detected |
| Comparative Preparation Example 2 | Comparative Example 2 | 600 ~ 700 | 800 ~ 900 | Detected |
| Comparative Preparation Example 3 | Comparative Example 3 | 350 ~ 400 | 300 ~ 450 | Not detected |
| Comparative Preparation Example 4 | Comparative Example 4 | 900 ~ 1100 | 850 ~ 1100 | Detected |
| Comparative Preparation Example 5 | Comparative Example 5 | 750 ~ 800 | 800 ~ 900 | Detected |

### Experimental Example 2: Measurement of solar cell device performance

The current-voltage characteristics and efficiency of the solar cells manufactured in Preparation Examples 1 to 9 and Comparative Preparation Examples 1 to 5 were measured, and the results are shown in Table 3 below.

**[Table 3]**

| Classification | Type of coating liquid | Open-circuit voltage (V_{oc}, V) | Short-circuit current density (J_{sc}, mA/cm²) | Fill factor (FF,%) | Photoelectric conversion efficiency (%) |
|---|---|---|---|---|---|
| Preparation Example 1 | Example 1 | 1.8391 | 18.184 | 72.271 | 24.169 |
| Preparation Example 2 | Example 2 | 1.8322 | 18.201 | 72.072 | 24.034 |
| Preparation Example 3 | Example 3 | 1.8291 | 18.501 | 71.012 | 24.030 |
| Preparation Example 4 | Example 4 | 1.7802 | 18.802 | 70.054 | 23.448 |
| Preparation Example 5 | Example 5 | 1.8010 | 17.801 | 70.012 | 22.445 |
| Preparation Example 6 | Example 6 | 1.7702 | 18.801 | 67.012 | 22.302 |
| Preparation Example 7 | Example 7 | 1.8312 | 18.199 | 72.101 | 24.029 |
| Preparation Example 8 | Example 8 | 1.8299 | 18.285 | 72.005 | 24.092 |
| Preparation Example 9 | Example 9 | 1.8301 | 18.211 | 72.095 | 24.027 |
| Comparative Preparation Example 1 | Comparative Example 1 | 1.8288 | 17.975 | 70.749 | 23.258 |
| Comparative Preparation Example 2 | Comparative Example 2 | 1.7702 | 18.820 | 68.012 | 22.658 |
| Comparative Preparation Example 3 | Comparative Example 3 | 1.7751 | 17.702 | 69.801 | 21.933 |
| Comparative Preparation Example 4 | Comparative Example 4 | 1.7602 | 18.810 | 66.112 | 21.889 |
| Comparative Preparation Example 5 | Comparative Example 5 | 1.7710 | 18.760 | 66.012 | 21.919 |

As can be confirmed through Table 3 above, in the case of the tandem devices of Preparation Examples 1 to 9, due to the large grain size of the light-absorbing layer, the short-circuit current density (J_{SC}) increased. Even when the perovskite thickness increased, due to the effect of the relatively reduced grain boundaries, the open-circuit voltage (V_{OC}) increased, and due to the improved perovskite thin-film quality, the fill factor (FF) was improved. Therefore, it can be confirmed that the efficiency was improved in all efficiency parameters when compared with the photoelectric conversion devices such as that of Comparative Preparation Example 1. Additionally, in the case of Comparative Preparation Example 2 to which the coating agent of Comparative Example 2 prepared using 115 mM, which exceeds 100 mM, of the Lewis base adduct former concentration in the coating agent was applied, the thickness and grain size of the light-absorbing layer were not significantly problematic. However, due to the increase in intermediates combined with the perovskite precursor and the Lewis base, PbI₂ crystals that were not crystallized into perovskite were generated such that there was a problem in which the FF and the voltage (V_{OC}) were greatly reduced.

Additionally, in the case of Comparative Preparation Example 3 to which the coating agent of Comparative Example 3 using a perovskite precursor concentration of 0.80 M, which is less than 0.90 M, was applied, when compared with Preparation Example 5 (Example 5), there was a problem of current reduction, as well as voltage and FF reduction, due to insufficient grain size and thickness. Further, in the case of Comparative Preparation Example 3 to which the coating agent of Comparative Example 3 using a perovskite precursor concentration of 0.80 M, which is less than 0.90 M, was applied, when compared with Preparation Example 6 (Example 6), it could be confirmed that there was a problem in which the current was greatly reduced.

Additionally, in the case of Comparative Preparation Example 5 to which the coating agent using the perovskite compound of Chemical Formula 3-3 was applied, when compared with Preparation Examples 1 to 9, the photoelectric conversion efficiency was relatively low. Through this, it could be confirmed that the use of the Lewis base adduct former for a perovskite compound that is not a Cs-based perovskite compound is inappropriate.

Through the above examples and experimental examples, it could be confirmed that a high-quality large-area perovskite thin film having a large average grain size while securing uniformity can be commercially manufactured, and it could be confirmed that the perovskite solar cell manufactured using the same has a high photoelectric conversion efficiency.

## Claims

1. A coating agent for forming a large-area perovskite thin film, comprising:
a Lewis base adduct former comprising one or more selected from a compound represented by Chemical Formula 1 below, diphenyl carbonate, dialkyl dicarbonate and diaryl dicarbonate; and
a perovskite precursor solution: 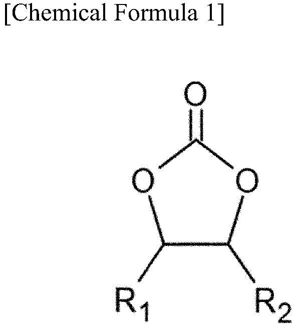
wherein in Chemical Formula 1, R₁ and R₂ are each independently a hydrogen atom, a C₁-C₅ straight-chain alkyl group, a C₃-C₅ branched alkyl group or a phenyl group.

2. The coating agent of claim 1, wherein the Lewis base adduct former is comprised at a concentration of 5 mM to 100 mM.

3. The coating agent of claim 1, wherein the perovskite precursor solution comprises a perovskite precursor represented by Chemical Formula 2 below and a solvent:
[Chemical Formula 2] ABX₃
wherein in Chemical Formula 2, A comprises two or more selected from a monovalent organic ammonium ion and a monovalent inorganic cation, M is a divalent metal ion, and X comprises two or more halogen ions selected from F⁻, Cl⁻, Br⁻ and I⁻.

4. The coating agent of claim 3, wherein the perovskite precursor solution comprises the perovskite precursor at a concentration of 0.9 to 2.0 M.

5. The coating agent of claim 3, wherein the solvent comprises one or more selected from dimethyl sulfoxide (DMSO), N-methylpyrrolidone (NMP), thiourea, thioacetamide, pyridine, aniline, N,N'-dimethylpropyleneurea (DMPU), 1-cyclohexyl-2-pyrrolidone (CHP), acetonitrile (MeCN) and acetone.

6. The coating agent of claim 3, wherein the perovskite precursor is a perovskite precursor represented by Chemical Formula 3 below:
[Chemical Formula 3] AₘA'₁₋ₘB(XₙX'₁₋ₙ)₃
wherein in Chemical Formula 3, A is methylammonium (MA), formamidinium (FA), ethylamine (EA), guanidinium (GA) or ethylenediamine (EDA), A' is Cs⁺, Na⁺, K⁺, NH₄⁺ or Rb⁺, B is Pb²⁺, Sn²⁺, Pd²⁺, Cu²⁺, Ge²⁺, Sr²⁺, Cd²⁺, Ca²⁺, Ni²⁺, Mn²⁺, Fe²⁺, Co²⁺, Sn²⁺, Yb²⁺ or Eu²⁺, X and X' are each independently Cl⁻, Br⁻, or I⁻, and m and n are rational numbers satisfying 0.6 ≤ m ≤ 0.9 and 0.5 ≤ n ≤ 0.9.

7. A method for forming a large-area perovskite thin film having an area of 200 cm² or more, the method comprising:
step 1 of preparing the coating agent according to any one of claims 1 to 6;
step 2 of forming a wet-thin film comprising perovskite that is crystallized as an intermediate phase by performing a coating process and drying of the coating agent on an upper portion of a substrate; and
step 3 of forming a large-area perovskite thin film by performing an annealing process on the wet-thin film.

8. The method of claim 7, wherein the large-area perovskite thin film has an average grain size of perovskite crystals on a surface of 300 nm or more.

9. The method of claim 7, wherein the substrate on which the coating agent is coated is a Si thin-film layer, a hole transport layer, an electron transport layer or a passivation layer.

10. The method of claim 7, wherein the coating process is performed by blade coating, slot-die coating, bar coating, inkjet coating or spray coating.

11. The method of claim 7, wherein the drying is performed together with the coating process, or is performed after completion of the coating process.

12. The method of claim 11, wherein the drying is performed by a N₂ or clean dry air (CDA) knife-blowing process to evaporate a solvent.

13. The method of claim 7, wherein the annealing is performed by heat treatment at 95 to 150°C for 5 to 30 minutes.

14. A large-area perovskite solar cell, comprising a large-area perovskite thin film formed of the coating agent according to any one of claims 1 to 6 as a light-absorbing layer,
wherein the large-area perovskite thin film has an average grain size of perovskite crystals on a surface of 300 nm or more.

15. A perovskite tandem solar cell, comprising:
a top cell comprising a large-area perovskite thin film formed of the coating agent according to any one of claims 1 to 6 as a light-absorbing layer; and
a bottom cell comprising Si, Cu(In,Ga)Se₃, CdTe or a perovskite compound as a light-absorbing layer,
wherein the large-area perovskite thin film of the top cell has an average grain size of perovskite crystals on a surface of 300 nm or more.
